(19) Europäisches Patentamt
European Patent Office
Office européen des brevets

(11) **EP 3 019 989 B1**

(12) **FASCICULE DE BREVET EUROPEEN**

(45) Date de publication et mention de la délivrance du brevet:
**30.10.2024 Bulletin 2024/44**

(21) Numéro de dépôt: **14750560.6**

(22) Date de dépôt: **07.07.2014**

(51) Classification Internationale des Brevets (IPC):
***G06F 30/20*** (2020.01)      ***G06F 30/17*** (2020.01)

(52) Classification Coopérative des Brevets (CPC):
**G06F 30/20;** G06F 30/17

(86) Numéro de dépôt international:
**PCT/FR2014/051744**

(87) Numéro de publication internationale:
**WO 2015/004377 (15.01.2015 Gazette 2015/02)**

(54) **PROCÉDÉ DE FABRICATION D'UNE SURFACE NON-AXISYMÉTRIQUE**

VERFAHREN ZUR HERSTELLUNG EINER NICHT AXIALSYMMETRISCHEN OBERFLÄCHE

METHOD FOR MANUFACTURING A NON-AXISYMMETRIC SURFACE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.07.2013 FR 1356732**

(43) Date de publication de la demande:
**18.05.2016 Bulletin 2016/20**

(73) Titulaire: **Safran Aircraft Engines
75015 Paris (FR)**

(72) Inventeurs:
• **CELLIER, Damien Joseph**
  **F-77550 Moissy-Cramayel Cedex (FR)**
• **PERROT, Vincent**
  **F-77550 Moissy-Cramayel Cedex (FR)**
• **VOLLEBREGT, Matthieu Jean Luc**
  **F-77550 Moissy-Cramayel Cedex (FR)**
• **PIGNIER, Nicolas Jean Fernand**
  **F-77550 Moissy-Cramayel Cedex (FR)**

(74) Mandataire: **Regimbeau
20, rue de Chazelles
75847 Paris Cedex 17 (FR)**

(56) Documents cités:
**WO-A1-2007/011355      WO-A1-2012/107677**

• **MANUEL A BURGOS ET AL: "Rapid meshing of turbomachinery rows using semi-unstructured multi-block conformal grids", ENGINEERING WITH COMPUTERS ; AN INTERNATIONAL JOURNAL FOR SIMULATION-BASED ENGINEERING, SPRINGER-VERLAG, LO, vol. 26, no. 4, 15 December 2009 (2009-12-15), pages 351 - 362, XP019845738, ISSN: 1435-5663**
• **K C GIANNAKOGLOU: "A Design Method For Turbine Blades Using Genetic Algorithms On Parallel Computers", COMPUTATIONAL FLUID DYNAMICS, 1 January 1998 (1998-01-01), pages 1 - 6, XP055099589, Retrieved from the Internet <URL:http://velos0.ltt.mech.ntua.gr/research/pdfs/3_041.pdf> [retrieved on 20140131]**
• **DUCCIO BONAIUTI ET AL: "Analysis and Optimization of Transonic Centrifugal Compressor Impellers Using the Design of Experiments Technique", JOURNAL OF TURBOMACHINERY, vol. 128, no. 4, 1 January 2006 (2006-01-01), pages 786, XP055010480, ISSN: 0889-504X, DOI: 10.1115/1.1579507**

**Description**

DOMAINE TECHNIQUE GENERAL

La présente invention concerne la conception assistée par ordinateur.

Plus précisément, elle concerne un procédé de fabrication d'une surface non-axisymétrique d'une pièce telle qu'un moyeu ou un carter.

ETAT DE L'ART

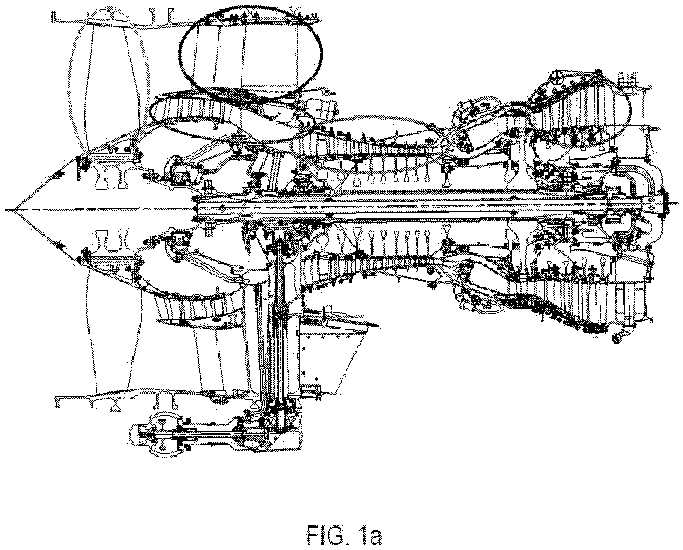

La nécessité d'amélioration constante des performances des équipements, en particulier aéronautiques, par exemple des rotors de turboréacteurs (c'est-à-dire l'ensemble formé d'un moyeu sur lequel sont fixées des aubes s'étendant radialement, tel que visible sur la figure 1a), a aujourd'hui imposé l'utilisation d'outils informatiques de modélisation.

Ces outils permettent d'aider à concevoir des pièces en optimisant de façon automatisée certaines de leurs caractéristiques par l'exécution d'un grand nombre de calculs de simulation.

La recherche d'un optimum géométrique aéromécanique et/ou acoustique sur les rotors conduit aujourd'hui à l'obtention de moyeux présentant une paroi localement non-axisymétrique (c'est-à-dire qu'une coupe selon un plan perpendiculaire à l'axe de rotation n'est circulaire) au niveau de la veine, c'est-à-dire l'ensemble des canaux entre les aubes pour l'écoulement de fluide (en d'autres termes les sections inter-aubes), au vu des conditions particulières qui y règnent. La veine non-axisymétrique définit une surface globalement annulaire d'un espace tridimensionnel (une « tranche » du moyeu).

De façon générale, pour optimiser une caractéristique d'une pièce, il est nécessaire de paramétriser une loi (en d'autres termes une ou plusieurs courbes décrivant la valeur d'une grandeur physique selon une courbe le long de la pièce, dans un environnement donné) que l'on cherche à optimiser, c'est-à-dire d'en faire une fonction de N paramètres d'entrée. L'optimisation consiste alors à faire varier (en général aléatoirement) ces différents paramètres sous contrainte, jusqu'à déterminer leurs valeurs optimales pour un critère prédéterminé. Une courbe « lissée » est ensuite obtenue par interpolation à partir des points de passage déterminés.

Le nombre de calculs nécessaires est alors directement lié (linéairement voire exponentiellement) au nombre de paramètres d'entrée du problème.

De nombreuses méthodes de paramétrisation d'une loi existent, et on peut en particulier distinguer deux grandes catégories :

- Modèle discret : la loi est définie par la position d'une pluralité de points, déplacés un à un lors de l'optimisation ;
- Modèle paramétrique : la loi est définie via des courbes mathématiques connues dans la littérature, telles que les courbes de Bézier ou les courbes NURBS (B-splines rationnelles non uniformes).

Dans le cas précis des veines non-axisymétriques, des méthodologies spécifiques de paramétrisation ont été développées. On peut distinguer une famille de méthodes, dites à modification par points d'attraction au niveau de la paroi, i.e. définition de creux et de bosses, qui consiste à partir d'une surface axisymétrique, et à la faire apparaître des creux et des bosses.

Alternativement, il a été proposé des méthodes dites à modification par caractérisation de « sections ». On dessine alors chaque section de passage du fluide entre deux aubes, et l'évolution de la paroi selon ces sections.

En d'autres termes on paramétrise des lois selon une pluralité de chemins d'écoulement du fluide entre les aubes (en reprenant la méthodologie générale expliquées ci-avant), de sorte à définir une pluralité de surfaces élémentaires correspondant à la veine sur tout le pourtour de la paroi.

Bien que plus intéressantes du point de vue aérodynamique, les méthodes par caractérisation de section sont bien plus complexes et peu utilisées.

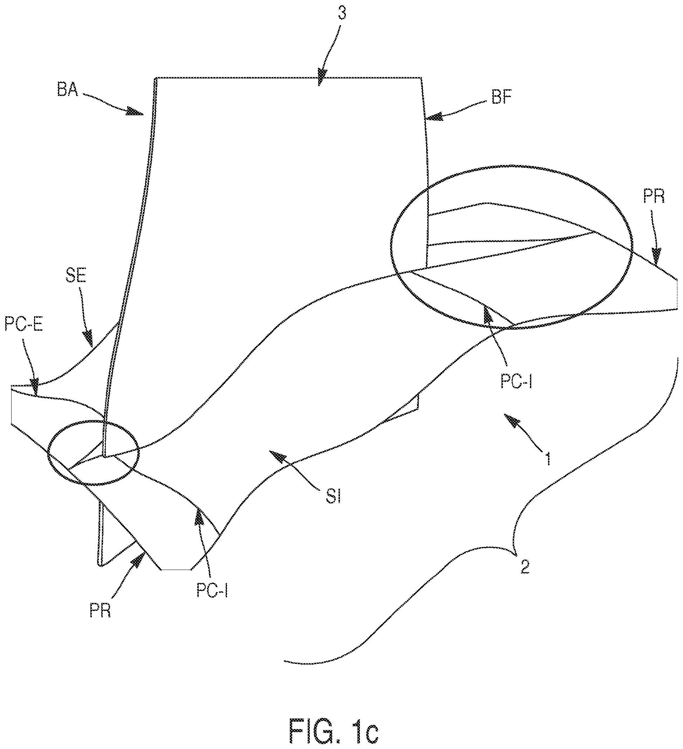

En effet, comme l'on voit sur la figure 1c qui sera décrite plus loin, une des difficultés qui en résulte porte sur la continuité entre les surfaces élémentaires, en particulier à l'amont et à l'aval de l'aube. En effet, la section peut n'être pas la même à l'intrados et à l'extrados de l'aube. Ce qui implique une « marche » problématique à l'amont et à l'aval de l'aubage.

Il n'existe aujourd'hui pas de méthode par caractérisation de sections qui permette de conserver une géométrie aéromécaniquement saine (i.e. sans aucune singularité).

Il serait souhaitable de trouver une nouvelle façon de modéliser une surface non-axisymétrique dans sa globalité, répondant aux exigences de continuité de la paroi, de respect des contraintes de fabrication, et ce tout en laissant à l'utilisateur une importante marge de manoeuvre dans le design.

Manuel A. Burgos et al., "Rapid meshing of turbomachinery rows using semi-unstructured multi-block conformal grids", Engineering with Computers, An International Journal for Simulation-based Engineering, vol. 26, no. 4, 15 décembre 2009, pages 351-362, XP019845738, divulgue un algorithme de maillage d'une pièce de turbomachine, et la modification de la géométrie d'une pièce de turbomachine afin de résoudre des discontinuités.

WO 2012/107677 A1, Snecma, 16 août 2012, divulgue un procédé qui modifie localement la forme de l'une pale de manière à rehausser la courbe de squelette afin d'adapter la pale à la modification du flux induite par une dépression circonférentielle aménagée dans la plateforme.

K. C. Giannakoglou, "A Design Method For Turbine Blades Using Genetic Algorithms On Parallel Computers", Computational Fluid Dynamics, 1 janvier 1998, pages 1-6, XP055099589, divulgue un procédé de conception d'aubes de turbomachine au moyen d'algorithmes génétiques.

WO 2007/011355 A1, HONEYWELL INT. INC., 25 janvier 2007, divulgue un procédé de conception d'aube au moyen de courbes de Bézier.

Duccio Bonaiuti et al.: "Analysis and Optimization of Transonic Centrifugal Compressor Impellers Using the Design of Experiments Technique", Journal of Turbomachinery, vol. 128, no. 4, 1 janvier 2006, page 786, XP055010480, divulgue un procédé d'optimisation de pièces de turbomachines.

PRESENTATION DE L'INVENTION

L'invention est exposée dans le jeu de revendications joint.

Le présent procédé correspond à une méthode par caractérisation de sections dans laquelle on ne cherche pas éviter les discontinuités, bien au contraire. Ces dernières sont obtenues, puis corrigées a posteriori sans modifier la géométrie de la surface non-axisymétrique, de sorte à garder tous les avantages de ces méthodes (qualités aérodynamiques et importante marge de manoeuvre), sans les désavantages (singularités).

En outre, le procédé est particulièrement optimisé pour améliorer au mieux la qualité des modèles tout en diminuant la puissance de calcul requise.

Selon d'autres caractéristiques :

- une pluralité d'aubes est disposée sur la circonférence de la portion de pièce, chaque surface élémentaire s'étendant entre deux aubes, de sorte que les première et deuxième surfaces élémentaires sont disposées de part et d'autre d'une aube, respectivement sur l'intrados et l'extrados ;
- la jonction entre les première et deuxième surfaces élémentaires présente une première discontinuité s'étendant du premier plan extrémal au bord d'attaque de l'aube et une deuxième discontinuité s'étendant du bord de fuite de l'aube au deuxième plan extrémal ;
- une courbe de raccord est construite à l'étape (b) pour chacune des première et deuxième discontinuités, chaque courbe de raccord étant tangente à l'aube au niveau du bord de fuite ou du bord d'attaque ;
- une courbe de raccord passe par un point milieu disposé sur le bord de fuite ou du bord d'attaque de l'aube de sorte que la distance entre le point milieu et la première surface élémentaire est égale à la distance entre le point milieu et la deuxième surface élémentaire ;
- une courbe de raccord est une spline entièrement définie par les points extrémaux et le point milieu ;
- l'étape (c) comprend pour chacune des première et deuxième discontinuité la construction d'une surface de raccord présentant en tout point de son bord une continuité de tangence avec la première ou la deuxième surface élémentaire ;
- chaque surface élémentaire présente au moins une courbe de construction disposée entre le bord d'attaque et le bord de fuite de l'aube, chacune des deux surfaces de raccord s'étendant sur chacune des première et deuxième surfaces élémentaires d'un bord extrémal jusqu'à la première courbe de construction au-delà de la courbe de raccord ;
- l'étape (a) comprend pour chaque courbe de construction de chaque surface élémentaire la mise en oeuvre de sous-étapes de :

  (a1) Paramétrisation de la courbe de construction en tant que courbe de classe $C^1$ représentant la valeur d'une grandeur physique caractéristique de ladite surface en fonction d'une position le long d'une largeur de la surface élémentaire, la courbe étant définie par :

  - Deux points de contrôle extrémaux, respectivement sur chacune des deux aubes entre lesquelles ladite surface élémentaire s'étend, définissant l'étendue de ladite largeur de la surface élémentaire ;
  - Au moins une spline ;

  la paramétrisation étant mise en oeuvre selon un ou plusieurs paramètres définissant au moins un des points de contrôle extrémaux ;
  (a2) Détermination de valeurs optimisées desdits paramètres de ladite courbe.

- chaque courbe de construction de chaque surface élémentaire est également définie par au moins un point de contrôle intermédiaire disposé entre les points extrémaux, et au moins deux splines connectées au niveau dudit point de contrôle intermédiaire ; la paramétrisation étant également mise en oeuvre selon un ou plusieurs paramètres définissant ledit point de contrôle intermédiaire ;
- le ou les paramètres définissant un point de contrôle intermédiaire ou extrémal définissant une courbe de construction sont choisis parmi une abscisse du point, une ordonnée du point, une orientation de tangente à la courbe au niveau du point et au moins un coefficient de tension associé à une demi-tangente à la courbe au niveau du point ;
- un coefficient de tension associé à une demi-tangente à la courbe au niveau d'un point intermédiaire ou extrémal est fonction d'une valeur de dérivée seconde de la courbe au voisinage du point ;
- chaque spline d'une courbe de construction est une courbe de Bézier entièrement déterminée par les points de contrôle définissant ses extrémités.

## PRESENTATION DES FIGURES

D'autres caractéristiques et avantages de la présente invention apparaîtront à la lecture de la description qui va suivre d'un mode de réalisation préférentiel. Cette description sera donnée en référence aux dessins annexés dans lesquels :

- la figure 1a précédemment décrite représente un exemple de réacteur sur des parois duquel le procédé selon l'invention est mis en oeuvre ;
- les figures 1b-1c illustrent un détail d'une veine non-axisymétrique ;
- la figure 2 représente un système pour la mise en oeuvre du procédé selon l'invention ;
- les figures 3a-3b représentent deux exemples de courbes de construction d'une surface élémentaire utilisées par le procédé selon l'invention ;
- la figure 4a-4d illustrent la construction d'une surface de raccord au niveau d'un bord d'attaque ;
- la figure 5 représente une courbe de raccord utilisée par le procédé selon l'invention.

## DESCRIPTION DETAILLEE

Le présent procédé vise à la fabrication d'au moins une partie d'une surface non-axisymétrique d'une portion d'une pièce. Cette pièce peut être un moyeu ou un carter, et de façon générale toute pièce d'un réacteur présentant une paroi interne/externe contre laquelle l'air circule. En référence à la figure 1a précédemment introduite (qui représente un réacteur CFM-56), on pourra citer les zones suivantes (qui ont été entourées pour faciliter leur localisation) :

- Fan
- OGV (« Outlet Guide Vane », i.e. aubages redresseurs du flux secondaire) + bras secondaire
- Booster + bras primaire
- Compresseur Haute Pression
- Turbine Haute Pression
- Turbine Basse Pression.

Dans la suite de la présente description, on prendra l'exemple d'une modélisation du moyeu au niveau de la zone Compresseur Haute Pression (troisième zone entourée en partant de la gauche ou de la droite), mais l'homme du métier saura transposer à n'importe quelle autre pièce du réacteur.

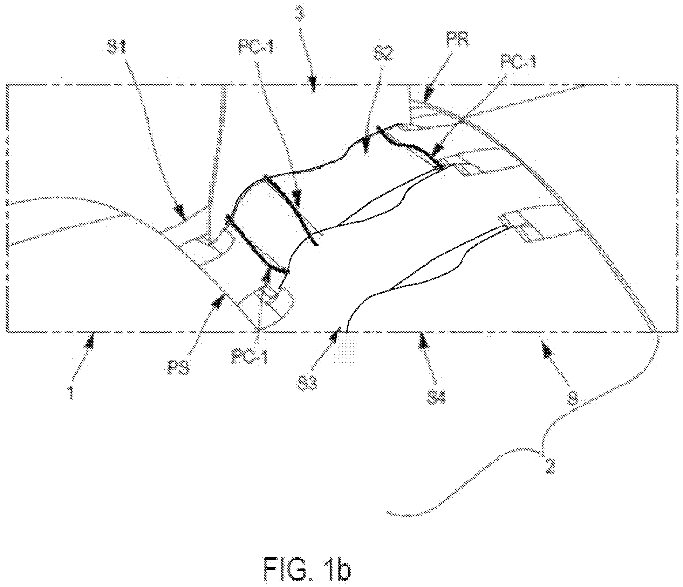

On observe sur la **figure 1b** ce moyeu 1 et en particulier une portion 2 non-axisymétrique, limitée en amont par un premier plan extrémal, le « Plan de séparation » PS et en aval par un deuxième plan extrémal, le « Plan de raccord » PR. Il est à noter que le moyeu peut présenter une pluralité de portions 2 (par exemple dans le cas de plusieurs rangs d'aubes), éventuellement séparées par des zones axisymétriques.

La portion 2 présente une surface S définissant une forme sensiblement torique, dont au moins une partie est modélisée par le présent procédé.

Comme expliqué, ce dernier reprend les méthodes dites à modification par caractérisation de « sections ». Ce procédé propose une solution innovante aux problèmes de continuité : au lieu de chercher à tout prix à éviter les discontinuités entre deux sections, le procédé va au contraire ne rien faire pour empêche leur apparition, puis va les supprimer a posteriori en utilisant des courbes de raccord, qui seront décrites plus loin.

La partie de la surface S modélisée comprend ainsi au moins deux surfaces élémentaires (sur la figure 1a, on compte quatre surfaces élémentaires référencées Sk, $k \in [\![1;4]\!]$ ), surface élémentaires qui sont modélisées indépendamment via la construction d'au moins une courbe de construction, appelée également « Plan de construction », lors d'une première étape (a) qui va être décrite plus loin (sur la figure 1a, trois courbes de construction PC-k définissent la première des surfaces élémentaires Sk).

Chacune de ces surfaces élémentaires présente une forme sensiblement rectangulaire et s'étend entre les deux plans extrémaux PS, PR de la portion 2. La surface S est ainsi reconstituée sous la forme d'une pluralité de bandes juxtaposées.

Deux surfaces élémentaires voisines $S_k$ et $S_{k+1}$ présentent une frontière particulière. Comme l'on voit toujours sur les figures, une première et une deuxième surfaces élémentaires voisines sont juxtaposées de sorte à présenter une jonction au moins C$^1$ au niveau des plans extrémaux PS, PR. En d'autres termes, l'intersection entre le moyeu 1 et chacun des plans PR et PS définit une courbe continue et de dérivée continue (cette courbe est fermée et forme une boucle), courbe que respectent les surfaces élémentaires au niveau de leurs extrémités, d'où la continuité de valeur et de dérivée au niveau des points de juxtaposition.

Entre leurs deux extrémités, le bord « commun » à deux surfaces élémentaires juxtaposées présente au moins une discontinuité, c'est-à-dire un point tel que les surfaces élémentaires soient disjointes.

De façon plus formelle, en définissant un référentiel cylindrique centré sur l'axe du moyeu 1 (tout point de la surface du moyeu est défini par un triplet $(r, \theta, z)$, avec $r$ le rayon, c'est-à-dire la distance entre le point de la paroi et l'axe du moyeu, ($\theta$ l'angle sur la circonférence du moyeu, et $z$ la position selon l'axe du moyeu), on a :

La portion 2 peut être définie par $\{(r, \theta, z), z \in [z_S, z_R]\}$;
PS et PR peuvent être respectivement définis par $\{(r, \theta, z), r = r_S, z = z_S\}$ et $\{(r, \theta, z), r = r_R, z = z_R\}$ ;
Une surface élémentaire $S_k$ peut être définie par une équation $\{(r_k(\theta, z), \theta, z), z \in [z_S, z_R], \theta \in [\theta_k, \theta_{k+1}], r_k(\theta, z_S) = r_S, r_k(\theta, z_R) = z_R\}$, telle que $\exists z \in ]z_S, z_R[, r_k(\theta_k, z) \neq r_{k+1}(\theta_k, z)$, ce qui définit le point de discontinuité.

Généralement, cette discontinuité se vérifie sur tout l'intervalle ouvert $]z_S, z_R[$ (en d'autres termes, la seule continuité s'observe sur PR et PS).

Comme on voit en particulier sur la figure 1b, la paroi du moyeu 1 est traversée par des aubes (en d'autres termes des pales). Ces aubes 3, disposées régulièrement ou non (dans ce second cas, on peut procéder par mise à l'échelle) sur la circonférence de la paroi 2, s'étendent radialement.

On obtient une alternance d'aubes et de surfaces élémentaires. En d'autres termes, chaque surface élémentaire s'étend entre deux aubes, et encore en d'autres termes, une surface élémentaire est disposée de chaque côté d'une aube.

L'un de ces cotés est l'extrados de l'aube, et l'autre est l'intrados. Ainsi, pour une aube 3 donnée (telle que celle représentée par la figure 1b), on peut définir un surface élémentaire d'intrados SI et une surface élémentaire d'extrados SE, qui sont deux surfaces élémentaires juxtaposées. On repère en outre les courbes de constructions PC-I et PC-E de chacune de ces deux surfaces élémentaires SI, SE. De même, une surface élémentaire donné est à la fois la surface élémentaire d'intrados SI d'une aube la bordant, et la surface élémentaire d'extrados SE de l'autre aube la bordant.

On comprendra par ailleurs qu'il est possible de modéliser toute surface élémentaire Sk comme l'union de deux « demi-surfaces » chacune s'étendant sur une moitié de la largeur de la veine. La demi-surface « de droite » joue donc le rôle de surface d'extrados d'une aube la bordant, et la demi-surface « de gauche » le rôle de surface d'intrados de l'autre aube voisine. Ce n'est toutefois qu'une convention de représentation parmi d'autres, et ne change rien dans la mise en oeuvre du procédé.

Dans la suite de la présente description, on prendra le cas simple d'une aube 3 entourée de deux surfaces élémentaires juxtaposées : la première est la surface élémentaire d'extrados SE de l'aube, et la deuxième est la surface élémentaire d'intrados SI de l'aube.

L'aube 3 occupe la majeure part de la jonction, mais laisse une première discontinuité « d'attaque » s'étendant du premier plan extrémal PS au bord d'attaque BA de l'aube 3 et une deuxième discontinuité s'étendant du bord de fuite BF de l'aube 3 au deuxième plan extrémal PR.

Le présent procédé permet la construction d'une surface de raccord SR pour chacune des première et deuxième discontinuités (surfaces SR qui seront représentées sur des figures qui seront décrites plus loin).

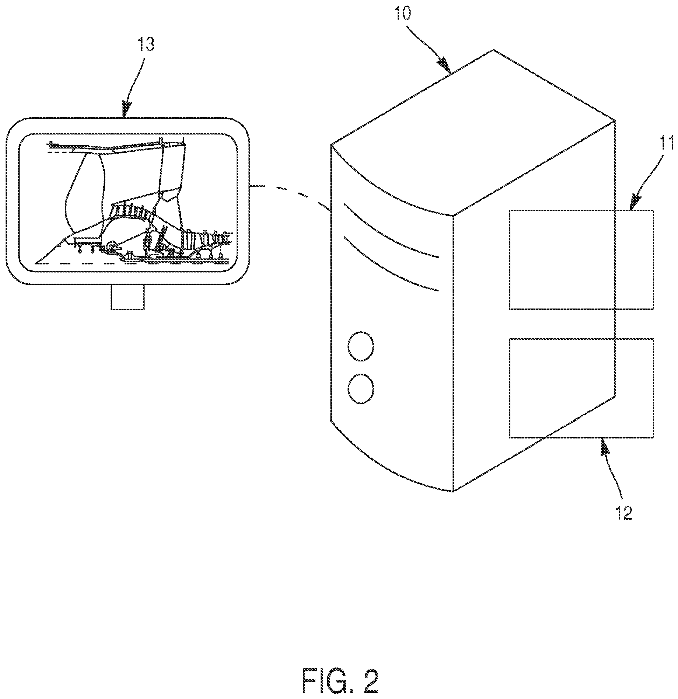

De façon générale, la partie de la surface S est modélisée dans le présent procédé, lors de sa conception, via un équipement informatique 10 du type de celui représenté sur la **figure 2**. Il comprend des moyens de traitement de données 11 (un ou plusieurs processeur), des moyens de stockage de données 12 (par exemple un ou plusieurs disques dur), des moyens d'interface 13 (composés de moyens de saisie tels qu'un clavier et une souris ou une interface tactile, et de moyens de restitution tels qu'un écran pour affichage des résultats). De façon avantageuse, l'équipement 10 est un supercalculateur, mais on comprendra qu'une mise en oeuvre sur des plateformes variées est tout à fait possible.

*Modélisation des surfaces élémentaires*

La première partie (a) du présent procédé voit la modélisation des surfaces élémentaires Sk, SI, SE indépendamment les unes de autres. Il est à noter que dans l'hypothèse avantageuse (mais non limitative) d'une périodicité dans la circonférence du moyeu (c'est-à-dire si les aubes 3 sont identiques et réparties uniformément), toutes les surfaces élémentaires seront identiques et il suffit d'en modéliser une puis de la dupliquer

Le principe est de déterminer un optimum géométrique aéromécanique et/ou acoustique, de lois d'une surface élémentaire, en d'autres termes d'une ou plusieurs courbes décrivant la valeur d'une grandeur physique (en particulier le rayon, c'est-à-dire la distance d'un point de la surface élémentaire au centre du moyeu) le long d'une largeur de la surface élémentaire (comme expliqué avant, une surface élémentaire $S_k$ est ainsi définie par ses courbes de construction $PC_{-k}$, chacune s'étend selon un plan sensiblement parallèle aux plans extrémaux PS, PR de la portion 2) dans un environnement donné, par l'exécution d'un grand nombre de calculs de simulation.

De nombreux critères peuvent être choisis comme critères à optimiser lors de la modélisation d'une surface élémentaire. A titre d'exemple, on peut tenter de maximiser des propriétés mécaniques telles que la résistance aux contraintes mécaniques, les réponses fréquentielles, les déplacements des aubes 3, des propriétés aérodynamiques telles que le rendement, l'élévation de pression, la capacité de débit ou la marge au pompage, etc.

Pour cela il est nécessaire de paramétriser la loi que l'on cherche à optimiser, c'est-à-dire d'en faire une fonction de *N* paramètres d'entrée. L'optimisation consiste alors à faire varier (en général aléatoirement) ces différents paramètres sous contrainte, jusqu'à déterminer leurs valeurs optimales pour un critère prédéterminé. Une courbe « lissée » est ensuite obtenue par interpolation à partir des points de passage déterminés.

Le nombre de calculs nécessaires est alors directement lié (linéairement voire exponentiellement) au nombre de paramètres d'entrée du problème.

De nombreuses méthodes sont connues, mais de façon préférée on mettra en oeuvre une méthode similaire à celle décrite dans la demande de brevet FR1353439, qui permet une excellente qualité de modélisation, sans consommation élevée de puissance de calcul, tout en limitant le phénomène de Runge (« ondulation » excessive de la surface).

De façon plus générale, le procédé comprend avantageusement pour chaque courbe de construction PC-k, PC-I, PC-E de chaque surface élémentaire Sk, SI, SE la mise en oeuvre de sous-étapes de :

(a1) paramétrisation de la courbe de construction PC en tant que courbe de classe $C^1$ représentant la valeur d'une grandeur physique caractéristique de ladite surface S (typiquement le rayon) en fonction d'une position le long d'au moins le long d'une largeur de la surface élémentaire Sk, SI, SE, la courbe étant définie par :

- Deux points extrémaux $PCU_I$, $PCU_E$ (pour « Point de Contrôle Utilisateur ») respectivement sur l'intrados et l'extrados de ladite largeur de la surface élémentaire Sk, SI, SE ;
- Au moins une spline ;

la paramétrisation étant mise en oeuvre selon un ou plusieurs paramètres définissant au moins un des points de contrôle extrémaux $PCU_I$, $PCU_E$ ;
(a2) Détermination de valeurs optimisées desdits paramètres de ladite courbe.

La première sous-étape (a1) est mise en oeuvre par les moyens de traitement de données 11 sous contrôle d'un opérateur.

La position le long de la largeur de la surface élémentaire Sk, SI, SE est exprimée en fonction de la longueur de corde (en abscisse), et plus précisément la longueur de corde « normalisée », c'est-à-dire exprimée entre 0 et 1 lorsque l'on traverse la surface élémentaire Sk, SI, SE, en d'autres termes lorsqu'on passe d'une aube 3 à une autre. Il est à noter que comme expliqué, la surface élémentaire Sk, SI, SE est située au niveau de l'intrados de l'une de ces deux aubes 3, et de l'extrados de l'autre, c'est pourquoi le chemin correspond à un passage intrados-extrados.

On comprendra toutefois que l'invention n'est aucunement limitée à l'expression d'une courbe représentant la valeur d'une grandeur en fonction d'une largeur, et que d'autres repères sont possibles.

Cette courbe représentant la valeur d'une grandeur physique doit être comprise comme la modélisation d'une loi de cette grandeur physique (elle sera à ce titre désignée sous le nom de « courbe de modélisation » pour la distinguer des courbes de Bézier en termes de terminologie). Ladite grandeur physique peut être n'importe quelle grandeur ayant une signification aéromécanique et/ou acoustique pour la conception de surface élémentaires Sk, SI, SE, mais il s'agit typiquement du rayon mentionné avant.

La courbe de modélisation est de classe de régularité au moins $C^1$, c'est-à-dire qu'elle correspond à une fonction continue et au moins de $1^{ère}$ dérivée continue sur son espace de définition (la largeur de la surface élémentaire). On verra plus loin l'importance de cette condition. En pratique, la courbe obtenue est $C^\infty$ par morceaux (fonctions indéfiniment dérivables sur chaque intervalle), avec continuité de la courbe et de la dérivée au niveau d'éventuels raccords (les points de contrôle intermédiaires qui vont être définis). On comprendra qu'il s'agit de conditions minimales et que la courbe peut tout à fait être par exemple $C^\infty$ sur l'ensemble de son espace de définition.

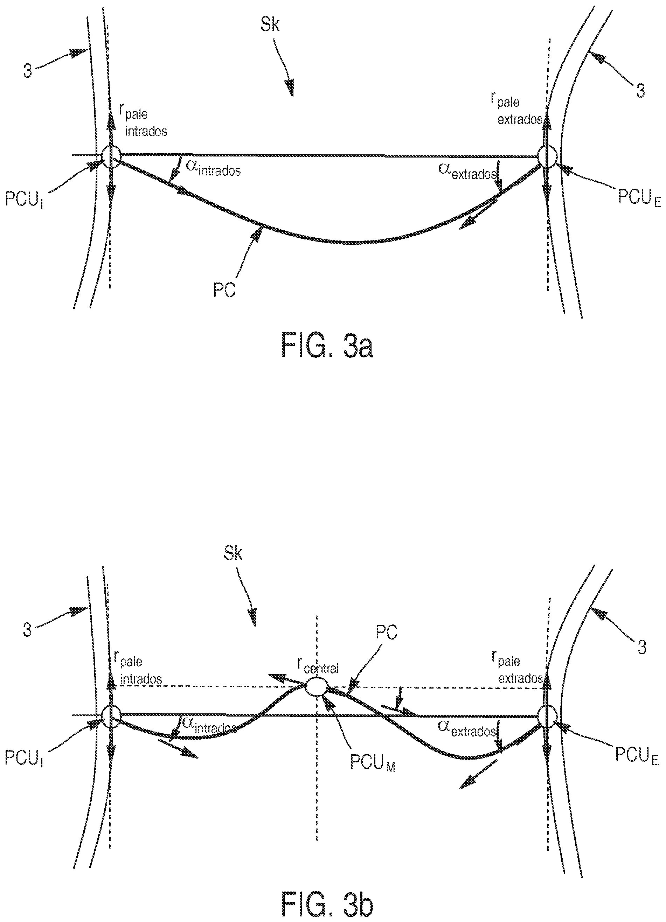

La courbe est définie grâce à ses points de contrôle. Comme l'on voit sur la **figure 3a**, qui représente un premier exemple de modélisation, deux points de contrôle utilisateur extrémaux $PCU_I$ et $PCU_E$ (qui sont respectivement les points de contrôle « Intrados » et « Extrados », selon le coté de l'aube 3 au niveau duquel ils se trouvent) sont fixés et définissent l'étendue de la surface élémentaire (i.e. le domaine de définition de la courbe).

La courbe de modélisation comprend au moins une spline qui relie ces points extrémaux. Les splines sont des courbes polynomiales paramétriques, parmi lesquelles on peut citer préférentiellement les courbes de Bézier définies comme combinaisons de $N+1$ polynômes élémentaires dits Polynômes de Bernstein : on définit une courbe de Bézier par l'ensemble de points

$$\sum_{i=0}^{N} B_i^N(t) \cdot \boldsymbol{P}_i \quad , \quad t \quad \in \quad [0,1], \quad \text{les}$$

$$B_i^N(t) = \binom{N}{i} t^N (1-t)^{N-i} \quad \text{étant les } N+1 \text{ polynômes de Bernstein de degré } N.$$

Les points $\{P_0, P_1...P_N\}$ sont appelés points de contrôle « implicites » de la courbe et constituent les variables grâce auxquelles une loi d'une surface élémentaire peut être modélisée par une courbe de Bézier.

Ces points sont appelés « implicites » car une courbe de Bézier peut être vue comme l'ensemble des barycentres des $N+1$ points de contrôle pondérés d'un poids égal à la valeur du polynôme de Bernstein associé à chaque point de contrôle. En d'autres termes, ces points agissent comme des poids localisés attirants la courbe généralement sans qu'elle n'y passe (hormis le premier et le dernier, correspondant respectivement à $t=0$ et $t=1$, et certains cas d'alignement de points).

De façon générale, dans les techniques de modélisation connues d'une loi utilisant une courbe de Bézier, les points de contrôle extrémaux $P_0$ et $P_N$ de la courbe utilisée sont fixés (ils définissent l'étendue sur laquelle la modélisation va être mise en oeuvre), mais les autres points $\{P_1...P_{N-1}\}$ présentent des coordonnées mobiles constituant les paramètres d'entrée pour l'algorithme d'optimisation.

Dans le présent procédé, un (voire plusieurs) point de contrôle utilisateur intermédiaire $PCU_M$ (pour « Milieu ») est disposé entre ces deux points extrémaux $PCU_I$ et $PCU_E$.

Ce cas est représenté par la **figure 3b**. Le ou les points intermédiaires sont des points de contrôle « explicite » et non implicite, car la courbe y passe. En effet, cette dernière comprend alors au moins deux splines connectées au niveau dudit point intermédiaire.

Dans un mode de réalisation, la courbe de modélisation peut être ainsi constituée seulement d'une séquence de courbes de Bézier, chacune s'étendant entre un point de contrôle extrémal $PCU_I$, $PCU_E$ et un point intermédiaire $PCU_M$, ou entre deux points intermédiaires $PCU_M$.

En d'autres termes, tous les points de contrôle utilisateur $PCU_I$, $PCU_N$, $PCU_E$ (extrémaux ou intermédiaires) de la courbe sont des points de contrôle extrémaux $P_0$, $P_N$ d'une courbe de Bézier.

Le fait que la courbe soit de classe $C^1$ impose que chaque point intermédiaire $PCU_M$ assure une continuité y compris sur la dérivée (même tangente).

Le traitement paramétrise la courbe de modélisation en fonction de paramètres de points de contrôle extrémaux (et éventuellement intermédiaires) définissant des extrémités de splines constituant la courbe de modélisation d'un plan de construction PC-k, PC-I, PC-E.

En particulier, Si ces splines sont des courbes de Bézier, chacune peut être entièrement déterminée par les points PCU définissant ses extrémités. En d'autres termes, les paramètres des points PCU (en termes de coordonnées, et de dérivées) servent de conditions aux limites pour le calcul par les moyens de traitement de données 11 des coordonnées des points de contrôle implicites des différentes courbes de Bézier, qui sont choisies du degré minimal suffisant pour satisfaire ces conditions limites. L'étape (a1) comprend alors la définition des points implicites des courbes de Bézier en fonction des paramètres des points PCU constituant leurs extrémités.

Le ou les paramètres définissant un point de contrôle PCU sont ainsi choisis parmi une abscisse du point, une ordonnée du point, une orientation de tangente à la courbe au niveau du point et un (dans le cas d'un point de contrôle extrémal $PCU_I$, $PCU_E$ : on ne peut prendre en compte que la demi-tangente dans le domaine de définition de la courbe, celle à gauche pour $PCU_E$ et celle à droite pour $PCU_I$) ou deux (dans le cas d'un point de contrôle intermédiaire $PCU_M$) coefficients de tension chacun associé à une demi-tangente à la courbe au niveau du point.

Sachant que la courbe est de classe $C^1$ (dérivée continue), l'orientation de la tangente doit être la même de part et d'autre d'un point intermédiaire $PCU_M$. En revanche, la « longueur » des deux demi-tangentes peut être différente de part et d'autre du point, longueur qui traduit la propension de chaque courbe de Bézier de part et d'autre du point à « coller » à la tangente. C'est ce que modélisent les « coefficients de tension » évoqués précédemment.

De façon concrète, chaque coefficient de tension associé à une demi-tangente à la courbe au niveau d'un point intermédiaire est fonction d'une valeur de dérivée seconde de la courbe au voisinage du point. En effet, la valeur de la dérivée seconde au voisinage du point de contrôle traduit la « vitesse » avec laquelle la courbe s'écarte de la tangente.

Et le fait que la courbe de modélisation ne soit pas forcément de classe $C^2$ autorise des discontinuités de dérivée seconde au niveau des points intermédiaires.

Il est à noter que tous les paramètres évoqués précédemment ne sont pas nécessairement effectivement utilisés. En effet, dans la majorité des cas, un ou plusieurs de ces paramètres (une abscisse du point, une ordonnée du point, une orientation de tangente à la courbe au niveau du point et deux coefficients de tension chacun associé à une demi-tangente à la courbe au niveau du point) présentent une valeur prédéterminée fixée par l'utilisateur, et ne sont donc pas utilisés comme « variables » pour la suite du procédé.

Selon une deuxième sous-étape (a2), le procédé comprend une étape de détermination par les moyens de traitement de données 11 de valeurs optimisées (et si possible optimales) desdits paramètres de ladite courbe. Il s'agit d'une étape d'optimisation.

De nombreuses techniques pour la mise en oeuvre de cette étape sont connues de l'homme du métier, et on pourra par exemple simplement faire varier pseudo-aléatoirement les paramètres choisis variables tout en effectuant des simulations pour déterminer ces valeurs optimisées (c'est-à-dire pour lesquelles le critère choisi est maximalisé) des paramètres des points de contrôle PCU. L'invention n'est toutefois pas limitée à cette possibilité.

Une fois les valeurs des paramètres déterminées, les moyens de traitement 11 obtiennent l'équation des courbes de constructions PC-k, PC-I, PC-E, et reconstruisent la totalité de la surface élémentaire Sk, SI, SE (en utilisant les équations des plans extrémaux PS, PR).

L'étape est éventuellement répétée pour modéliser diverses surfaces élémentaires Sk, SE, SI (alternativement, il est possible de considérer que toutes les surfaces élémentaires sont identiques et de simplement transposer la modélisation obtenue).

*Courbe de raccord*

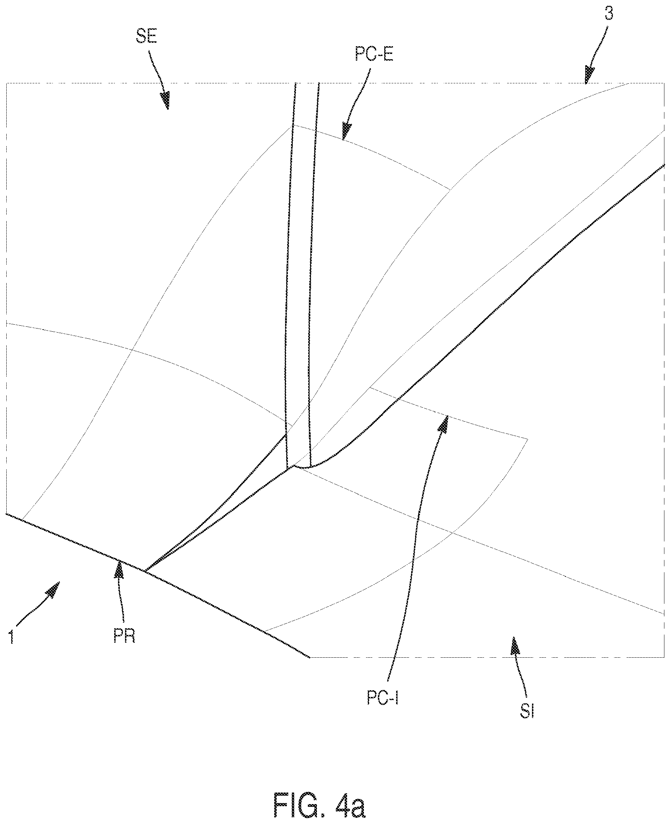

Une fois les première surface élémentaire SE et deuxième surface élémentaire SI modélisées (étape (a)), on obtient l'état représenté par la **figure 4a**. On constate la présence de la première discontinuité « d'attaque ». Dans la suite de la présente description, on verra uniquement l'exemple du traitement de cette première discontinuité, mais on comprendra que l'homme du métier pourra mettre en oeuvre les mêmes étapes au niveau de la deuxième discontinuité « de fuite ».

Il est à noter que les bords d'attaque BA et de fuite BF, sont ici des bords « réels » (c'est-à-dire les points qui sont réellement les plus en avant et en arrière de l'aube 3), quelques fois différents des bords théoriques (qui suivent le squelette de l'aube). Par exemple, la courbure de l'aube 3 fait que généralement le bord d'attaque BA est décalé vers l'intrados.

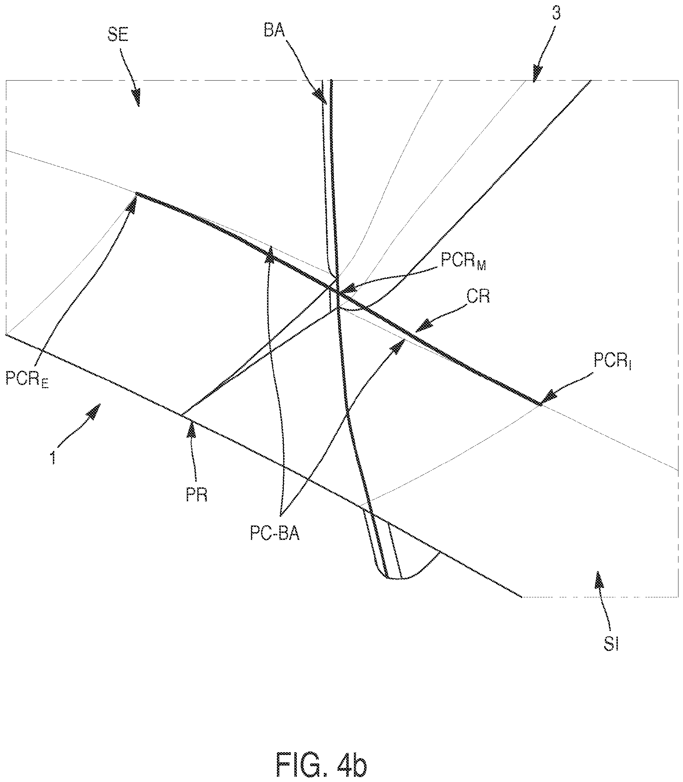

Les bords BA, BF réels apparaissent naturellement par construction lors de la mise en oeuvre du présent procédé. Par exemple, lorsqu'on observe la figure 4a, on constate pour chacune des surfaces élémentaires SE, SI un point d'intersection avec l'avant de l'aube 3 au niveau de l'extrémité de la discontinuité. Ces deux points définissent le bord d'attaque réel BA, matérialisé sur la **figure 4b**. Les courbes des surfaces élémentaires SE, SI concernées sont références PC-BA sur cette figure.

Le bord BA « réel » correspond en effet à une ligne de reflet, c'est-à-dire une courbe dont la normale à la surface (de l'aube 3) présente, en chaque point, le même angle par rapport à une direction déterminée, en l'espèce celle de la jonction entre les deux surfaces élémentaires SE, SI.

Cette prise en compte des bords réels BA, BF permet une correction automatique des erreurs dues à l'extrapolation du squelette de l'aube 3, et aide la mise en oeuvre de l'étape suivante du présent procédé.

Dans cette étape (b), est construite au moins une courbe de raccord CR de classe $C^1$ définie par un premier et un deuxième point extrémal $PCR_I$, $PCR_E$ (« point de contrôle de raccord ») respectivement disposés sur la première et la deuxième surface élémentaire Sk, SI, SE.

Typiquement, chaque point extrémal est sur une ligne médiane de la surface élémentaire SE, SI, les deux points passant par un plan parallèle aux plans PR, PS, de sorte à ce que la courbe de raccord soit tangente à l'aube 3 au niveau du bord de d'attaque BA (respectivement du bord de fuite BF).

La courbe de raccord CR est en outre tangente à la première et la deuxième surface SE, SI respectivement en le premier et le deuxième point extrémal $PCR_I$, $PCR_E$. On obtient la courbe CR telle que représentée sur la figure 4b.

La courbe de raccord CR passe par un point milieu $PCR_M$ disposé sur le bord d'attaque BA (respectivement le bord de fuite BF) de l'aube 3, de sorte que la distance entre le point milieu $PCR_M$ et la première surface élémentaire SE est égale à la distance entre le point milieu $PCR_M$ et la deuxième surface élémentaire SI.

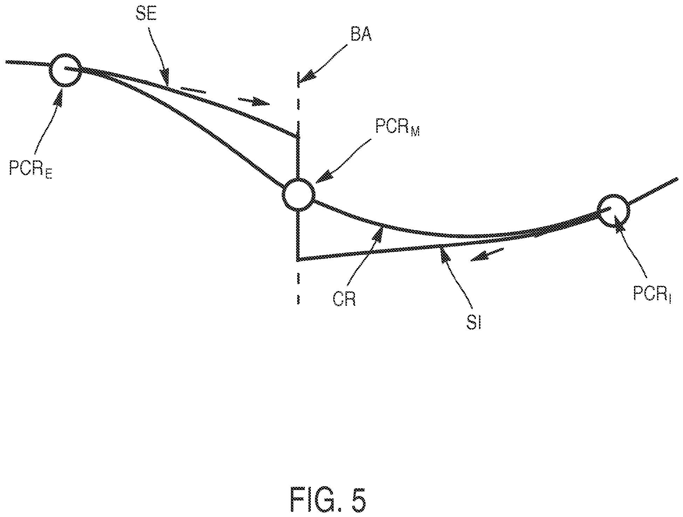

La **figure 5** permet de visualiser facilement cela : le point milieu $PCR_M$ est en d'autres termes au milieu de la marche existante entre les première et deuxième surfaces élémentaires SE, SI. On remarque également le respect des tangentes.

De nombreuses courbes de raccord CR satisfaisant ces conditions sont possible, mais de façon préférée cette dernière est une ou plusieurs splines (voire courbes de Béziers) entièrement définies par les points extrémaux $PCR_I$, $PCR_E$ et le point milieu $PCR_M$, de façon similaire à ce qui est utilisé pour la modélisation des plans de constructions PC-I, PC-E (voir ci-avant).

*Surface de raccord*

La courbe de raccord CR est utilisée par les moyens de traitement de données 11 pour définir une surface plus étendue, dite surface de raccord SR, qui recouvre la discontinuité. Ainsi, dans une étape (c), le procédé comprend la modification locale des première et deuxième surfaces élémentaires Sk, SI, SE de sorte à respecter ladite courbe de raccord au voisinage de ladite discontinuité.

Dans le cas des première et deuxième discontinuités d'attaque et de fuite, cette étape consiste en la construction de la surface de raccord SR présentant en tout point de son bord une continuité de tangence avec la première ou la deuxième surface élémentaire Sk, SI, SE. La surface de raccord SR remplace localement les surfaces élémentaires.

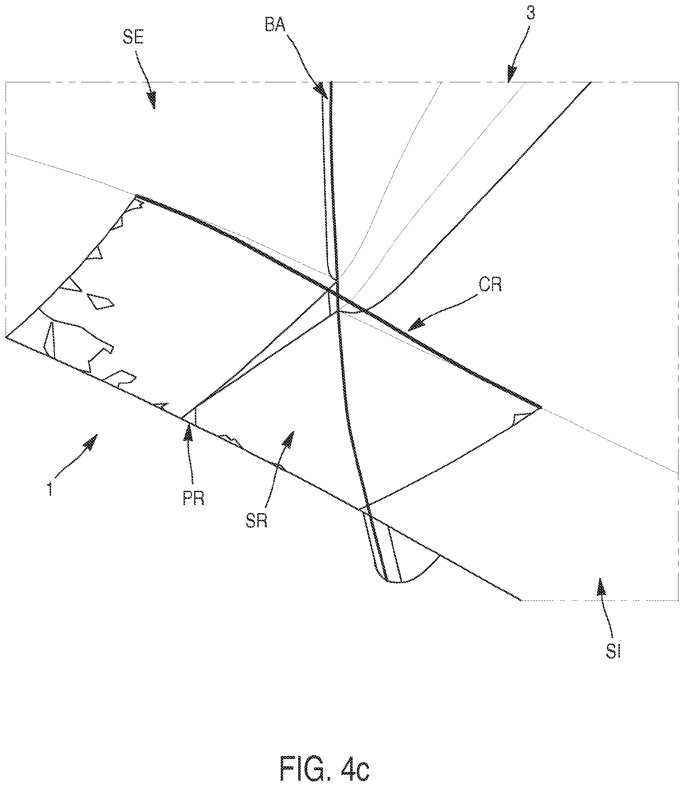

Comme représenté sur la **figure 4c**, cela comprend d'abord la construction d'une première moitié de la surface de raccord SR, qui s'étend d'un bord extrémal PR, PS de la portion 2 jusqu'à la courbe de construction CR. L'équation de chacun des bords de cette demi-surface est connue (dans le cas d'une forme sensiblement rectangulaire telle que visible sur la figure 4c, les quatre cotés sont respectivement définis par l'équation de SI, l'équation de PR, l'équation de SE, et l'équation de CR). En ce qui concerne l'intérieur de cette surface, n'importe quelle géométrie « saine » (continue, dérivable, et à la forme simple) peut faire l'affaire.

Arrivé à ce point, il existe toujours une discontinuité entre la surface de raccord SR et les surfaces élémentaires SE, SI au niveau de la courbe de raccord.

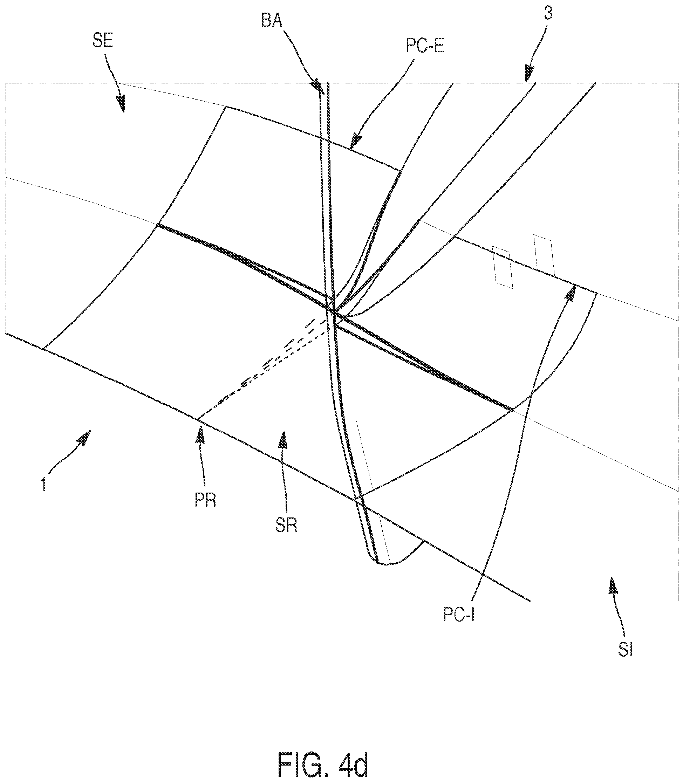

Il suffit alors d'étendre la surface de raccord SR le long de l'aube 3, en particulier jusqu'à atteindre une courbe de construction PC-I, PC-E de chacune des surfaces élémentaires SE, SI (il suffit que chaque surface élémentaire SI, SE présente au moins une courbe de construction PC-k, PC-I, PC-E disposée entre le bord d'attaque BA et le bord de fuite BF de l'aube 3 (en d'autres termes ailleurs qu'au niveau des discontinuités), de sorte que la surface de raccord SR s'étende jusqu'à la première courbe de construction PC-I, PC-E au-delà de la courbe de raccord CR), comme l'on voit sur la **figure 4d**. La surface de raccord SR continue à respecter en tout point de son bord une continuité de tangence.

La surface de raccord SR prend alors la forme d'un U autour de bord d'attaque BA (ou de fuite BF) de l'aube 3. L'ensemble formé par les surfaces élémentaires SE, SI et les surfaces de raccord SR est alors entièrement $C^1$ et respecte le squelette de l'aube 3. Il définit la partie de la surface S non-axisymétrique modélisée.

Dans une dernière étape (d), le modèle obtenu pour la surface S est restitué par les moyens d'interface 13 de l'équipement 10 pour exploitation, par exemple par l'affichage des surfaces en trois dimensions ou de leurs équations.

*Procédé de fabrication et pièce*

Une fois sa surface S modélisée, la pièce 1 (qui comme expliquée avant peut être notamment un moyeu ou un carter de réacteur) est fabriquée. Est ainsi proposé un procédé de fabrication d'une pièce dont une portion présente une surface non-axisymétrique, le procédé comprenant des étapes de :

- Mise en oeuvre du procédé selon le premier aspect de sorte à modéliser au moins une partie de ladite surface non-axisymétrique de la portion de la pièce ;
- Fabrication de ladite pièce conformément à la modélisation de l'au moins une partie de la surface obtenue.

La pièce ainsi obtenue (dont une portion présente une surface non-axisymétrique modélisée comme expliqué précédemment), présente une géométrie plus saine et de meilleure qualité que les pièces connues. Elle peut avoir une solidité augmentée, de meilleures propriétés aérodynamiques, des niveaux de bruit réduits, etc.

*Equipement*

L'équipement 10 (représenté sur la figure 2) pour la mise en oeuvre du procédé de modélisation d'au moins une partie d'une surface S non-axisymétrique d'une portion 2 d'une pièce 1 comprend des moyens de traitement de données 11 configurés pour mettre en oeuvre :

- Un module de modélisation des au moins deux surfaces élémentaires Sk, SI, SE non-axisymétriques composant ladite surface S, chacune des surfaces élémentaires Sk, SI, SE s'étendant entre les deux plans extrémaux PS, PR de la portion 2 et étant définie par au moins une courbe de construction PC-k, PC-I, PC-E s'étendant selon un plan sensiblement parallèle aux plans extrémaux PS, PR, une première et une deuxième surface élémentaire Sk, SI, SE étant juxtaposées de sorte à présenter une jonction au moins $C^1$ au niveau des plans extrémaux PS, PR et au moins une discontinuité ;
- Un module de construction d'au moins une courbe de raccord CR de classe $C^1$ définie par un premier et un deuxième point extrémal $PCR_I$, $PCR_E$ respectivement disposés sur la première et la deuxième surface élémentaire Sk, SI, SE, ladite courbe de raccord CR étant tangente à la première et la deuxième surface respectivement en le premier et le deuxième point extrémal $PCR_I$, $PCR_E$ ;
- Un module de modification locale des première et deuxième surfaces élémentaires Sk, SI, SE de sorte à respecter ladite courbe de raccord CR au voisinage de ladite discontinuité ;
- Un module de restitution sur une interface 13 dudit équipement 10 de l'au moins une partie de la surface S obtenue.

*Produit programme d'ordinateur*

L'invention concerne un produit programme d'ordinateur comprenant des instructions de code pour l'exécution (sur des moyens de traitement de données 11, en particulier ceux de l'équipement 10) d'un procédé de modélisation d'au moins une partie d'une surface S non-axisymétrique d'une portion 2 d'une pièce 1, ainsi que des moyens de stockage lisibles par un équipement informatique (par exemple une mémoire 12 de cet équipement 10) sur lequel on trouve ce produit programme d'ordinateur.

**Revendications**

1. Procédé de fabrication d'une pièce (1) d'un réacteur présentant une paroi interne ou externe contre laquelle l'air circule, une portion (2) appartenant à ladite paroi étant limitée par un premier et un deuxième plan extrémal (PS, PR), une pluralité d'aubes (3) étant disposée sur la circonférence de la portion (2) de la pièce (1), chaque aube (3) comprenant un bord d'attaque (BA) et un bord de fuite (BF), le procédé étant **caractérisé en ce qu'**il comprend :

   - la modélisation d'au moins une partie d'une surface (S) non-axisymétrique de la portion (2) de la pièce (1), comprenant la mise en oeuvre, par des moyens de traitement de données (11) d'un équipement (10), des étapes suivantes :

      (a) Modélisation d'au moins deux surfaces élémentaires (Sk, SI, SE) non-axisymétriques composant ladite surface (S), chacune des surfaces élémentaires (Sk, SI, SE) s'étendant entre les deux plans extrémaux (PS, PR) de la portion (2) et entre deux aubes (3), étant **caractérisée par** une loi décrivant une grandeur physique, ladite loi comprenant un optimum géométrique aéromécanique et/ou acoustique, et étant définie par au moins une courbe de construction (PC-k, PC-I, PC-E) s'étendant selon un plan sensiblement parallèle aux plans extrémaux (PS, PR),

      une première et une deuxième surface élémentaire (Sk, SI, SE) étant juxtaposées de sorte à être disposées de part et d'autre d'une aube (3), respectivement sur l'intrados et l'extrados, et à présenter une jonction au moins C1 au niveau des plans extrémaux (PS, PR), une première discontinuité s'étendant du premier plan extrémal (PS) au bord d'attaque (BA) de l'aube (3) et une deuxième discontinuité s'étendant du bord de fuite (BF) de l'aube (3) au deuxième plan extrémal (PR).

l'au moins une courbe de construction (PC-k, PC-I, PC-E) étant obtenue par détermination de l'optimum géométrique de chacune desdites surfaces élémentaires la grandeur physique étant choisie parmi des propriétés mécaniques telles que la résistance aux contraintes mécaniques, les réponses fréquentielles, les déplacements des aubes, des propriétés aérodynamiques telles que le rendement, l'élévation de pression, la capacité de débit ou la marge au pompage ;

(b) Construction d'une courbe de raccord (CR) de classe $C^1$ pour chacune des première et deuxième discontinuité, chaque courbe de raccord (CR) étant définie par un premier et un deuxième point extrémal ($PCR_I$, $PCR_E$) respectivement disposés sur la première et la deuxième surface élémentaire (Sk, SI, SE), étant tangente à la première et à la deuxième surface élémentaire respectivement en le premier et le deuxième point extrémal ($PCR_I$, $PCR_E$) et tangente à l'aube (3) au niveau du bord de fuite (BF) ou du bord d'attaque (BA), et au moins une courbe de raccord (CR) passant par un point milieu ($PCR_M$) disposé sur le bord de fuite (BF) ou le bord d'attaque (BA) de l'aube (3) de sorte que la distance entre le point milieu ($PCR_M$) et la première surface élémentaire (SE) est égale à la distance entre le point milieu ($PCR_M$) et la deuxième surface élémentaire (SI) ;

(c) Modification locale des première et deuxième surfaces élémentaires (Sk, SI, SE) de sorte à coïncider avec chacune desdites courbes de raccord (CR) en chacune desdites discontinuités ;

(d) Restitution sur une interface (13) dudit équipement (10) de l'au moins une partie de la surface (S) obtenue ;

- La fabrication de ladite pièce (1) conformément à la modélisation de l'au moins une partie de la surface (S) obtenue.

2. Procédé selon la revendication 1, dans lequel une courbe de raccord (CR) est une spline entièrement définie par les points extrémaux ($PCR_I$, $PCR_E$) et le point milieu ($PCR_M$).

3. Procédé selon l'une des revendications 1 à 2, dans lequel l'étape (c) comprend pour chacune des première et deuxième discontinuité la construction d'une surface de raccord (SR) présentant en tout point de son bord une continuité de tangence avec la première ou la deuxième surface élémentaire (Sk, SI, SE).

4. Procédé selon la revendication 3, dans lequel chaque surface élémentaire (Sk, SI, SE) présente au moins une courbe de construction (PC-k, PC-I, PC-E) disposée entre le bord d'attaque (BA) et le bord de fuite (BF) de l'aube (3), chacune des deux surfaces de raccord (SR) s'étendant sur chacune des première et deuxième surfaces élémentaires (Sk, SI, SE) d'un bord extrémal (PR, PS) jusqu'à la première courbe de construction (PC-k, PC-I, PC-E) au-delà de la courbe de raccord (CR).

5. Procédé selon l'une des revendications 1 à 4, dans lequel l'étape (a) comprend pour chaque courbe de construction (PC-k, PC-I, PC-E) de chaque surface élémentaire (Sk, SI, SE) la mise en oeuvre de sous-étapes de :

(a1) Paramétrisation de la courbe de construction (PC-k, PC-I, PC-E) en tant que courbe de classe $C^1$ représentant la valeur d'une grandeur physique caractéristique de ladite surface (S) en fonction d'une position le long d'une largeur de la surface élémentaire (Sk, SI, SE), la courbe étant définie par :

- Deux points de contrôle extrémaux ($PCU_I$, $PCU_E$), respectivement sur chacune des deux aubes (3) entre lesquelles ladite surface élémentaire (Sk, SI, SE) s'étend, définissant l'étendue de ladite largeur de la surface élémentaire (Sk, SI, SE) ;
- Au moins une spline ;

la paramétrisation étant mise en oeuvre selon un ou plusieurs paramètres définissant au moins un des points de contrôle extrémaux ($PCU_i$, $PCU_E$) ;

(a2) Détermination de valeurs optimisées desdits paramètres de ladite courbe.

6. Procédé selon la revendication 5, dans lequel chaque courbe de construction (PC-k, PC-I, PC-E) de chaque surface élémentaire (Sk, SI, SE) est également définie par au moins un point de contrôle intermédiaire ($PCU_M$) disposé entre les points extrémaux ($PCU_I$, $PCU_E$), et au moins deux splines connectées au niveau dudit point de contrôle intermédiaire ($PCU_M$) ;

la paramétrisation étant également mise en oeuvre selon un ou plusieurs paramètres définissant ledit point de contrôle intermédiaire ($PCU_M$).

7. Procédé selon l'une des revendications 5 et 6, dans lequel le ou les paramètres définissant un point de contrôle intermédiaire ou extrémal ($PCU_I$, $PCU_M$, $PCU_E$) définissant une courbe de construction (PC-k, PC-I, PC-E) sont choisis parmi une abscisse du point, une ordonnée du point, une orientation de tangente à la courbe au niveau du point et au moins un coefficient de tension associé à une demi-tangente à la courbe au niveau du point.

8. Procédé selon l'une des revendications 5 à 7, dans laquelle chaque spline d'une courbe de construction (PC-k, PC-I, PC-E) est une courbe de Béziers entièrement déterminée par les points de contrôle ($PCU_I$, $PCU_M$, $PCU_E$) définissant ses extrémités.

**Patentansprüche**

1. Verfahren zur Herstellung eines Teils (1) eines Reaktors mit einer Innen- oder Außenwand, gegen die Luft strömt, wobei ein zu der Wand gehörender Abschnitt (2) durch eine erste und eine zweite Endebene (PS, PR) begrenzt ist, wobei eine Vielzahl von Schaufeln (3) auf dem Umfang des Abschnitts (2) des Teils (1) angeordnet ist, wobei jede Schaufel (3) eine Vorderkante (BA) und eine Hinterkante (BF) umfasst, wobei das Verfahren **dadurch gekennzeichnet ist, dass** es umfasst:

- die Modellierung von mindestens einem Teil einer nicht-axialsymmetrischen Oberfläche (S) des Abschnitts (2) des Teils (1), umfassend die Durchführung der folgenden Schritte durch Datenverarbeitungsmittel (11) einer Ausrüstung (10):

(a) Modellierung von mindestens zwei nicht-axialsymmetrischen elementaren Oberflächen (Sk, SI, SE), die die Oberfläche (S) bilden, wobei sich jede der elementaren Oberflächen (Sk, SI, SE) zwischen den beiden Endebenen (PS, PR) des Abschnitts (2) und zwischen zwei Schaufeln (3) erstreckt, **gekennzeichnet durch** ein Gesetz, das eine physikalische Größe beschreibt, wobei das Gesetz ein geometrisches, aeromechanisches und/oder akustisches Optimum umfasst, und durch mindestens eine Konstruktionskurve (PC-k, PC-I, PC-E) definiert ist, die sich entlang einer Ebene erstreckt, die im Wesentlichen parallel zu den Endebenen (PS, PR) verläuft,

wobei eine erste und eine zweite elementare Oberfläche (Sk, SI, SE) derart nebeneinander liegen, dass sie auf beiden Seiten einer Schaufel (3), jeweils auf der Unterseite (intrados) und der Oberseite (extrados), angeordnet sind und eine Verbindung mindestens C1 im Bereich der Endebenen (PS, PR) aufweisen,

wobei sich eine erste Diskontinuität von der ersten Endebene (PS) zur Vorderkante (BA) der Schaufel (3) erstreckt, und sich eine zweite Diskontinuität von der Hinterkante (BF) der Schaufel (3) zur zweiten Endebene (PR) erstreckt, wobei die mindestens eine Konstruktionskurve (PCk, PC-I, PC-E) durch Bestimmen des geometrischen Optimums jeder der genannten elementaren Oberflächen erhalten wird, wobei die physikalische Größe aus mechanischen Eigenschaften wie Widerstand gegen mechanische Belastungen, Frequenzantworten, Verschiebungen der Schaufeln, aerodynamischen Eigenschaften wie Wirkungsgrad, Druckanstieg, Durchsatzleistung oder Pumpmarge ausgewählt ist;

(b) Konstruktion einer Verbindungskurve (CR) der Klasse $C^1$ für jede von der ersten und zweiten Diskontinuität, wobei jede Verbindungskurve (CR) durch einen ersten und einen zweiten Extrempunkt ($PCR_I$, $PCR_E$) definiert ist, die jeweils auf der ersten und der zweiten elementaren Oberfläche (Sk, SI, SE) angeordnet sind, tangential zur ersten und zur zweiten elementaren Oberfläche jeweils im ersten und im zweiten Extrempunkt ($PCR_I$, $PCR_E$) und tangential zur Schaufel (3) im Bereich der Hinterkante (BF) oder der Vorderkante (BA) verläuft, und mindestens einer Verbindungskurve (CR), die durch einen Mittelpunkt ($PCR_M$) verläuft, der an der Hinterkante (BF) oder der Vorderkante (BA) der Schaufel (3) angeordnet ist, so dass der Abstand zwischen dem Mittelpunkt ($PCR_M$) und der ersten elementaren Oberfläche (SE) gleich dem Abstand zwischen dem Mittelpunkt ($PCR_M$) und der zweiten elementaren Oberfläche (SI) ist;
(c) lokale Modifikation der ersten und zweiten elementaren Oberfläche (Sk, SI, SE), so dass sie mit jeder der Verbindungskurven (CR) in jeder der Diskontinuitäten zusammenfallen;
(d) Wiederherstellen des mindestens einen Teils der erhaltenen Oberfläche (S) auf einer Schnittstelle (13) der Ausrüstung (10);

- die Herstellung des Teils (1) gemäß der Modellierung des mindestens einen Teils der erhaltenen Oberfläche (S).

2. Verfahren nach Anspruch 1, wobei eine Verbindungskurve (CR) ein Spline ist, der vollständig durch die Extrempunkte (PCR$_I$, PCR$_E$) und den Mittelpunkt (PCR$_M$) definiert ist.

3. Verfahren nach einem der Ansprüche 1 bis 2, wobei Schritt (c) für jede von der ersten und zweiten Diskontinuität die Konstruktion einer Verbindungsoberfläche (SR) umfasst, die an jedem Punkt ihres Randes eine Berührungsstetigkeit mit der ersten oder der zweiten elementaren Oberfläche (Sk, SI, SE) aufweist.

4. Verfahren nach Anspruch 3, wobei jede elementare Oberfläche (Sk, SI, SE) mindestens eine Konstruktionskurve (PC-k, PC-I, PC-E) aufweist, die zwischen der Vorderkante (BA) und der Hinterkante (BF) der Schaufel (3) angeordnet ist, wobei sich jede der beiden Verbindungsflächen (SR) auf jeder von der ersten und zweiten elementaren Oberfläche (Sk, SI, SE) von einem Extremrand (PR, PS) bis zu der ersten Konstruktionskurve (PC-k, PC-I, PC-E) über die Verbindungskurve (CR) hinaus erstreckt.

5. Verfahren nach einem der Ansprüche 1 bis 4, wobei Schritt (a) für jede Konstruktionskurve (PC-k, PC-I, PC-E) jeder elementaren Oberfläche (Sk, SI, SE) die Durchführung folgender Teilschritte umfasst:

   (a1) Parametrisieren der Konstruktionskurve (PC-k, PC-I, PC-E) als eine Kurve der Klasse C$^1$, die den Wert einer für die Oberfläche (S) charakteristischen physikalischen Größe in Abhängigkeit von einer Position entlang einer Breite der elementaren Oberfläche (Sk, SI, SE) darstellt, wobei die Kurve definiert ist durch:

   - zwei extreme Kontrollpunkte (PCU$_I$, PCU$_E$) jeweils auf jeder der beiden Schaufeln (3), zwischen denen sich die elementare Oberfläche (Sk, SI, SE) erstreckt, die die Ausdehnung der Breite der elementaren Oberfläche (Sk, SI, SE) definieren;
   - mindestens ein Spline;

   wobei die Parametrisierung gemäß einem oder mehreren Parametern durchgeführt wird, die mindestens einen der extremen Kontrollpunkte (PCU$_I$, PCU$_E$) definieren;
   (a2) Bestimmen von optimierten Werten der Parameter der Kurve.

6. Verfahren nach Anspruch 5, wobei jede Konstruktionskurve (PC-k, PC-I, PC-E) jeder elementaren Oberfläche (Sk, SI, SE) ebenfalls durch mindestens einen zwischen den Extrempunkten (PCU$_I$, PCU$_E$) angeordneten Zwischenkontrollpunkt (PCU$_M$) und mindestens zwei mit dem Zwischenkontrollpunkt (PCU$_M$) verbundene Splines definiert wird; wobei die Parametrisierung ebenfalls gemäß einem oder mehreren Parametern, die den Zwischenkontrollpunkt (PCU$_M$) definieren, durchgeführt wird.

7. Verfahren nach einem der Ansprüche 5 und 6, wobei der oder die Parameter, die einen Zwischen- oder extremen Kontrollpunkt (PCU$_I$, PCU$_M$, PCU$_E$) definieren, der eine Konstruktionskurve (PC-k, PC-I, PC-E) definiert, ausgewählt sind aus einer Abszisse des Punktes, einer Ordinate des Punktes, einer Berührungsausrichtung der Kurve im Bereich des Punktes und mindestens einem Spannungskoeffizienten, der einer zur Kurve halben Tangente im Bereich des Punktes zugeordnet ist.

8. Verfahren nach einem der Ansprüche 5 bis 7, wobei jeder Spline einer Konstruktionskurve (PC-k, PC-I, PC-E) eine Bézier-Kurve ist, die vollständig durch die Kontrollpunkte (PCU$_I$, PCU$_M$, PCU$_E$) bestimmt wird, die ihre Enden definieren.

**Claims**

1. Method of manufacturing a part (1) of a reactor having an inner or outer wall against which air flows , a portion (2) belonging to said wall being bounded by a first and a second end plane (PS, PR), a plurality of vanes (3) being disposed on the circumference of the portion (2) of the part (1), each vane (3) comprising a leading edge (BA) and a trailing edge (BF), the method being **characterized in that** it comprises :

   - modeling of at least part of a non-axisymmetric surface (S) of the portion (2) of the part (1), comprising the implementation, by data processing means (11) of an equipment (10), of the following steps:

   (a) Modeling of at least two non-axisymmetric elementary surfaces (Sk, SI, SE) composing said surface (S), each of the elementary surfaces (Sk, SI, SE) extending between the two end planes (PS, PR) of the portion (2) and between two vanes (3), being **characterized by** a law describing a physical quantity, said law comprising an aeromechanical and/or acoustic geometric optimum , and being defined by at least one construction curve (PC-k, PC-I, PC-E) extending in a plane substantially parallel to the end planes (PS, PR),

   a first and a second elementary surface (Sk, SI, SE) being juxtaposed so as to be arranged on either side of a vane (3), respectively on the intrados and extrados, and to present a junction at least C1 at the end planes (PS, PR), a first discontinuity extending from the first end plane (PS) to the leading edge (BA) of the vane (3) and a second discontinuity extending from the trailing edge (BF) of the vane (3) to the second end plane (PR).

the at least one construction curve (PC-k, PC-I, PC-E) being obtained by determining the geometric optimum of each of said elementary surfaces the physical quantity being selected from mechanical properties such as resistance to mechanical stress, frequency responses, vane displacements, aerodynamic properties such as efficiency, pressure rise, flow capacity or pumping margin;

(b) Construction of a connection curve (CR) of class $C^1$ for each of the first and second discontinuities, each connection curve (CR) being defined by a first and a second end point (PCR$_I$ , PCR$_E$ ) respectively disposed on the first and second elementary surface (Sk, SI, SE), being tangent to the first and second elementary surface respectively at the first and second end point (PCR$_I$ , PCR$_E$ ) and tangent to the vane (3) at the trailing edge (BF) or leading edge (BA), and at least one connecting curve (CR) passing through a midpoint (PCR$_M$ ) arranged on the trailing edge (BF) or leading edge (BA) of the vane (3) so that the distance between the midpoint (PCR$_M$ ) and the first elementary surface (SE) is equal to the distance between the midpoint (PCR$_M$ ) and the second elementary surface (SI);

(c) Local modification of the first and second elementary surfaces (Sk, SI, SE) so as to coincide with each of said connection curves (CR) at each of said discontinuities;

(d) Restitution on an interface (13) of said equipment (10) of at least part of the surface (S) obtained;

- Manufacturing said part (1) in accordance with the modeling of at least part of the surface (S) obtained.

2. Method according to claim 1, in which a connection curve (CR) is a spline entirely defined by the end points (PCR$_I$ , PCR$_E$ ) and the midpoint (PCR$_M$ ).

3. Method according to one of claims 1 to 2, in which step (c) comprises for each of the first and second discontinuities the construction of a connecting surface (SR) having at any point of its edge a continuity of tangency with the first or second elementary surface (Sk, SI, SE).

4. Method according to claim 3, wherein each elementary surface (Sk, SI, SE) has at least one construction curve (PC-k, PC-I, PC-E) arranged between the leading edge (BA) and the trailing edge (BF) of the vane (3), each of the two connecting surfaces (SR) extends on each of the first and second elementary surfaces (Sk, SI, SE) from an end edge (PR, PS) to the first construction curve (PC-k, PC-I, PC-E) beyond the connecting curve (CR).

5. Method according to one of claims 1 to 4, wherein step (a) comprises for each construction curve (PC-k, PC-I, PC-E) of each elementary surface (Sk, SI, SE) the implementation of the substeps of :

(a1) Parameterization of the construction curve (PC-k, PC-I, PC-E) as a class C1 curve representing the value of a physical quantity characteristic of said surface (S) as a function of a position along a width of the elementary surface (Sk, SI, SE), the curve being defined by :

- Two end control points (PCU$_I$ , PCU$_E$ ), respectively on each of the two blades (3) between which said elementary surface (Sk, SI, SE) extends, defining the extent of said width of the elementary surface (Sk, SI, SE);
- At least one spline;

the parameterization being implemented according to one or more parameters defining at least one of the end control points (PCU$_I$, PCU$_E$ );

(a2) Determination of optimized values of said curve parameters.

6. Method according to claim 5, wherein each construction curve (PC-k, PC-I, PC-E) of each elementary surface (Sk, SI, SE) is also defined by at least one intermediate control point (PCU$_M$ ) arranged between the end points (PCU$_I$ , PCU$_E$ ), and at least two splines connected at said intermediate control point (PCU$_M$ );

the parametrization being also implemented according to one or more parameters defining said intermediate control point (PCU$_M$).

7. Method according to one of claims 5 and 6, wherein the parameter or parameters defining an intermediate or end control point (PCU$_I$ , PCU$_M$ , PCU$_E$ ) defining a construction curve (PC-k, PC-I, PC-E) are chosen from an abscissa of the point, an ordinate of the point, a tangent orientation to the curve at the point and at least one tension coefficient associated with a half-tangent to the curve at the point.

8. Method according to one of claims 5 to 7, wherein each spline of a construction curve (PC-k, PC-I, PC-E) is a Béziers curve determined entirely by the control points ($PCU_I$ , $PCU_M$ , $PCU_E$ ) defining its ends.

FIG. 1a

FIG. 1b

FIG. 1c

FIG. 2

FIG. 3a

FIG. 3b

SE

PC-E

3

1

PR

PC-I

SI

FIG. 4a

FIG. 4b

FIG. 4c

FIG. 4d

FIG. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012107677 A1, Snecma
- WO 2007011355 A1

- FR 1353439

**Littérature non-brevet citée dans la description**

- **MANUEL A. BURGOS et al.** Rapid meshing of turbomachinery rows using semi-unstructured multi-block conformal grids. *Engineering with Computers, An International Journal for Simulation-based Engineering,* 15 Décembre 2009, vol. 26, 351-362

- **K. C. GIANNAKOGLOU.** A Design Method For Turbine Blades Using Genetic Algorithms On Parallel Computers. *Computational Fluid Dynamics,* 01 Janvier 1998, 1-6
- **DUCCIO BONAIUTI et al.** Analysis and Optimization of Transonic Centrifugal Compressor Impellers Using the Design of Experiments Technique. *Journal of Turbomachinery,* 01 Janvier 2006, vol. 128 (4), 786